# EUROPÄISCHE PATENTSCHRIFT

(11) **EP 2 502 471 B1**
(45) Veröffentlichungstag und Bekanntmachung des Hinweises auf die Patenterteilung: **10.12.2014**
(21) Anmeldenummer: 10768418.5
(22) Anmeldetag: 19.10.2010
(51) Int. Cl.: H05K 3/46, H05K 1/16, H05K 3/12, H03K 17/96

(54) **HERSTELLUNG VON LEITERSTRUKTUREN AUF KUNSTSTOFF-FOLIEN MITTELS NANOTINTEN**
PRODUCTION OF CONDUCTOR STRUCTURES ON PLASTIC FILMS BY MEANS OF NANO-INKS
FABRICATION DE STRUCTURES DE CONDUCTEUR SUR DES FILMS EN MATIÈRE PLASTIQUE AU MOYEN DE NANO-ENCRES

(30) Priorität: 21.10.2009 DE 102009050199
(43) Veröffentlichungstag der Anmeldung: 26.09.2012
(73) Patentinhaber: Giesecke & Devrient GmbH, 81677 München (DE)
(72) Erfinder: WELLING, Ando, 84424 Isen (DE)
(86) Internationale Anmeldenummer: PCT/EP2010/006387
(87) Internationale Veröffentlichungsnummer: WO 2011/047835

(56) Entgegenhaltungen:
- EP-A1- 1 832 632
- EP-A1- 2 119 747
- US-A1- 2005 136 638
- US-A1- 2005 150 684
- US-A1- 2005 207 930

## Beschreibung

Gegenstand der vorliegenden Erfindung ist ein Verfahren zur Herstellung eines Laminatmaterials, das mindestens zwei Folienschichten und mindestens eine elektrisch leitfähige Leiterstruktur zwischen den Folienschichten aufweist, wobei mindestens die der elektrisch leitfähigen Leiterstruktur benachbarten Folienschichten elektrisch isolierend und heißlaminierbar sind. Gegenstand der vorliegenden Erfindung ist auch ein mittels des erfindungsgemäßen Verfahrens erhältliches Laminatmaterial mit mindestens einer elektrisch leitfähigen Leiterstruktur. Gegenstand der vorliegenden Erfindung sind außerdem mit dem erfindungsgemäßen Laminatmaterial hergestellte Produkte, wie elektronische Schaltungseinheiten mit IC-Chip und Spule für beispielsweise kontaktlose Datenträger in Flachmaterialform, sowie Folienschaltelemente, die als Kartenkörper einer Chipkarte ausgebildet oder in eine Chipkarte oder in ein sonstiges Flachmaterial integriert werden können.

Die kontaktlose Datenübermittlung gewinnt zunehmend an Bedeutung, beispielsweise für Warenprüfungszwecke und Warenkontrollzwecke, zur Kennzeichnung von Waren unterschiedlichster Art zur Verhinderung von Fälschung oder Diebstahl, und insbesondere auch für elektronische Ausweise. Als Datenträger wirkt dabei typischerweise ein IC-Chip mit Antenne. Der Chip besteht aus einer Mehrzahl von elektronischen Bauteilen, und die Antenne ist eine elektrisch leitfähige Schicht, typischerweise in Spulenform. Die gespeicherte Information kann ausgelesen werden und beispielsweise auf einem Display angezeigt werden oder bestimmte mechanische Reaktionen hervorrufen, beispielsweise den Zugang zu einem bestimmten Gebäudebereich freigeben oder sperren. Es ist wünschenswert, die kontaktlosen Schaltungseinheiten möglichst klein und insbesondere flach zu halten, um sie in Form von Etiketten auf der Oberfläche von Gegenständen anbringen zu können oder als Inletts in den Schichtaufbau einer Karte, zum Beispiel eines Ausweises, oder eines sonstigen flachen Gegenstands integrieren zu können.

Eine derartige Schaltungseinheit ist beispielsweise aus der EP 0 756 244 A2 bekannt. Die offenbarte Schaltungseinheit umfasst mindestens ein isolierendes Trägersubstrat, auf dem sich eine leitende, flache Spule befindet, und einen integrierten Schaltkreis, dessen Anschlusspunkte direkt oder über Kontakte leitend mit den Spulenenden verbunden oder kapazitiv gekoppelt sind. Auf dem isolierenden Trägersubstrat sind im Wechsel Spulenlagen und isolierende Schichten aufgebracht, wobei jede isolierende Schicht wenigstens eine Durchbrechung aufweist, durch die die angrenzenden Spulenlagen leitend miteinander verbunden sind, oder wobei die angrenzenden Spulenlagen kapazitiv gekoppelt sind, so dass aus den einzelnen Spulenlagen eine Spule entsteht. Die Spulenlagen werden vorzugsweise mit einem leitenden Lack aufgedruckt oder unter Verwendung einer entsprechenden Maske aufgesprüht beziehungsweise aus einer leitenden Beschichtung, die sich auf dem Trägersubstrat befindet, ausgeätzt. Andere bekannte Herstellungsverfahren sind beispielsweise, die Spule in Form einer elektrisch leitenden Beschichtung im Heißprägeverfahren auf das Trägersubstrat aufzubringen, oder die Spule aus einer Metallfolie oder einer elektrisch leitend beschichteten Kunststoff-Folie auszustanzen und auf das Trägersubstrat aufzubringen.

US 2005/150684 A1 offenbart eine elektronische Vorrichtung, welche eine Vielzahl von Komponenten, Nanopartikel zum Verbinden der Komponenten und einer Empfangsschicht zum Anordnen der Nanopartikel umfasst, wobei die Empfangsschicht auf mindestens einer der verbundenen Komponenten angeordnet ist. Die elektronische Vorrichtung kann ferner eine Elektrode enthalten, welche auf wenigstens einer Komponente aus der Vielzahl von Komponenten angeordnet ist. Die Empfangsschicht ist auf der Oberfläche der Elektrode angeordnet. In der Empfangsschicht sind leitfähige Partikel vermischt mit dem Material der Empfangsschicht angeordnet.

US 2005/136638 A1 offenbart eine Zusammensetzung, die eine Mischung von Nanopartikeln aus Silber und Gold enthält. Die Zusammensetzung kann auf ein Substrat aufgebracht und gesintert werden, um ein leitendes Element zu bilden.

EP 1 832 632 A1 offenbart eine leitende Tinte, welche umfasst
(a) 10 bis 75 Gewicht-Prozent eines Lösungsmittels
(b) 0 bis 50 Gewicht-Prozent mindestens eines strahlungshärtbaren Materials mit einem Mn im Bereich von 70 bis 10.000 g/Mol
(c) 5 bis 70 Gewicht-Prozent wenigstens eines Polyurethans mit einem Mw im Bereich von 4.000 bis 70.000 g/Mol und
(d) 20 bis 85 Gewicht-Prozent eines leitenden Materials.

US 2005/207930 A1 offenbart eine Erfindung, welche ausreichend ein Verhältnis zwischen Bauelement und Leiter in einer Verdrahtung sichert, welche auf einer mehrlagigen Leiterplatte angeordnet sind, und erhöht die Zuverlässigkeit durch die Herstellung der mehrlagigen Leiterplatte mittels eines Verdrahtungsmusters bestehend aus einer Paste zur Bildung von Verdrahtungsleitern, welche enthält
(a) superfeine Metallteilchen (Metallnanoteilchen), deren mittlere Teilchengröße 1 bis 10 Nanometer beträgt,
(b) eine organische Beschichtungsmasse, welche auf der Oberfläche der superfeinen Metallteilchen in einer Filmdicke von 1 bis 10 Nanometer angeordnet ist,
(c) eine latent reaktive organische Verbindung, welche mit der organischen Beschichtungsmasse im Bereich von 100 bis 250 Grad Celsius reagiert,
(d) Metallteilchen mit einer mittleren Teilchengröße von 0,5 bis 10 Mikrometern, und
(e) einem Dispersionsmedium, das stabil die Komponenten (a) bis (d) auf einem Substrat durch Siebdruck stabil dispergiert, Sintern durch Erhitzen der Muster auf 100-250 Grad Celsius und elektrochemische Behandlung der Verdrahtungsmuster, um es dem Leiter zu ermöglichen in einer gewünschten Querschnittsfläche sich auf der Innenseite des Verdrahtungsmusters abzuscheiden.

Ein bevorzugtes Verfahren zur Herstellung von Spulenlagen und anderen Leiterstrukturen ist ein ätzfreies Siebdruckverfahren, bei dem eine Druckpaste mit einem leitenden Werkstoff aufgedruckt wird. Nach dem Drucken wird das Trägersubstrat einer Wärmebehandlung unterzogen, um flüchtige Bestandteile der Druckpaste zu entfernen.

Häufig ist es auch erwünscht, elektronische Funktionselemente, wie Chipmodule, zu aktivieren beziehungsweise zu deaktivieren, d.h. an- und abzuschalten. Zu diesem Zweck sind Folien-Schaltelemente beziehungsweise Folien-Taster bekannt. Zur Herstellung eines Folien-Schaltelements werden mehrere Folienschichten, zwischen denen ein Schaltkontakt hergestellt werden soll, übereinander geschichtet und miteinander verklebt. Dabei wird zwischen zwei elektrisch leitenden Schaltfolien (Kontaktfolien) eine gelochte und elektrisch isolierende Zwischenfolie angeordnet, die als Abstandshalter dient und verhindert, dass sich die Kontaktfolien im Ruhezustand des Folien-Schaltelementes berühren. Die Zwischenfolie bewirkt somit, dass das Folien-Schaltelement im Ruhezustand geöffnet ist. Durch Ausübung eines Drucks auf mindestens eine der beiden Kontaktfolien im Bereich der Lochung der Zwischenfolie wird die Kontaktfolie deformiert und ein elektrischer Kontakt zwischen den beiden Kontaktfolien hergestellt. Wenn kein Druck mehr ausgeübt wird, nimmt die Kontaktfolie in Folge ihrer Elastizität wieder ihre ursprüngliche Form an. Dadurch wird der elektrische Kontakt zwischen den beiden Kontaktfolien unterbrochen. Das Folien-Schaltelement schließt daher den Leiterkreis nur während der Ausübung eines Drucks auf mindestens eine der beiden Kontaktfolien und öffnet ihn wieder beim Nachlassen des Drucks.

Der Kontakt zwischen den Schaltfolien des "Schalters" und die Verbindung des Schalters zu den Funktionselementen wird durch elektrisch leitfähige Leiterstrukturen hergestellt. Diese Strukturen können in der gleichen Weise erzeugt werden wie die oben genannten flachen Spulen, wobei die drucktechnische Erzeugung bevorzugt ist.

Besonders bevorzugt werden zur Herstellung der Leiterstrukturen, wie Leiterbahnen, Leitflächen und Kontaktflächen, Pasten mit metallischen Partikeln verwendet, beispielsweise Silberleitpasten mit Silberpartikeln, die auf die Folien aufgedruckt werden. Dabei ergibt sich das Problem, dass Schaltungseinheiten und Folienschaltelemente, die zur Integration in Chipkarten oder für Folientastaturen oder sonstige flachen Gegenstände geeignet sind, in der Regel aus Kunststoff-Folien bestehen, das heißt, die Leiterstrukturen müssen auf Kunststoff-Folien ausgebildet werden, wobei die Folien zudem häufig dünn sind mit Dicken im Bereich von etwa 50 µm bis 300 µm. Derartige Kunststoff-Folien neigen jedoch bei höheren Temperaturen dazu, sich zu verziehen, sich zu wellen und schlimmstenfalls zu schrumpfen. Diese Eigenschaft schränkt die Möglichkeiten zur Erzeugung flacher Leiterstrukturen auf Kunststoff-Folien ein. Mittels Leitpasten mit metallischen Partikeln aufgedruckte Strukturen können nur bei moderaten Temperaturen getrocknet werden, bei den üblichen Trägerfolien, wie beispielsweise PVC, bei maximal 50°C.

Bei derartigen Temperaturen kann kein Versintern der die Leiterstrukturen bildenden Metallpartikel stattfinden. Die Folge ist eine im Vergleich zu massiven metallischen Leiterstrukturen schlechte elektrische Leitfähigkeit und ein hoher Metallverbrauch, um eine akzeptable Leitfähigkeit zu erzielen. Da die Leiterstrukturen bevorzugt mit Edelmetallen, wie Silber, hergestellt werden, bedingt ein hoher Metallverbrauch gleichzeitig auch hohe Kosten. Dennoch sind die erzielten elektrischen Leitfähigkeiten verbesserungsbedürftig. Mit Silberleitpasten lassen sich im günstigsten Fall Werte von etwa einem Zehntel der Leitfähigkeit von massivem Silber erzielen, typischerweise deutlich weniger, etwa ein Zwanzigstel der Leitfähigkeit von massivem Silber. Es besteht daher ein Bedarf an einem verbesserten Verfahren zur Erzeugung elektrischer Leiterstrukturen für elektronische Schaltungseinheiten und andere in Flachmaterialien, wie beispielsweise Chipkarten, integrierbare, elektrisch leitfähige Leiterstrukturen aufweisende Elemente.

Aufgabe der vorliegenden Erfindung ist es daher, ein Verfahren bereitzustellen, das es ermöglicht, flache Leiterstrukturen auf nicht Temperaturformstabilen Trägersubstraten, wie Kunststoff-Folien, auszubilden.

Aufgabe der vorliegenden Erfindung ist es auch, ein derartiges Verfahren bereitzustellen, mit dem die Leiterstrukturen unkompliziert und kostengünstig erzeugt werden können.

Weitere Aufgaben der vorliegenden Erfindung bestehen darin, Leiterstrukturen mit verbesserter elektrischer Leitfähigkeit zu erzeugen, wobei die verbesserte elektrische Leitfähigkeit mit möglichst geringem Materialaufwand erzielt werden soll.

Aufgabe der vorliegenden Erfindung ist es außerdem, Flachmaterialien mit derartigen Leiterstrukturen bereitzustellen, die mit Funktionselementen, wie einem IC-Chip ausgestattet sind oder ausgestattet werden können, und die dazu geeignet sind, in einen Kartenaufbau integriert zu werden.

Aufgabe der vorliegenden Erfindung ist es darüber hinaus, Karten mit derartigen Leiterstrukturen und elektronischen Funktionselementen bereitzustellen, wie kontaktlose Datenträger.

Die Aufgaben werden gelöst durch das Verfahren zur Herstellung eines Laminatmaterials mit den Merkmalen, wie sie im unabhängigen Anspruch 1 angegeben sind.

Ausgestaltungen des erfindungsgemäßen Gegenstands sind in den jeweiligen abhängigen Ansprüchen angegeben.

Der Kerngedanke der vorliegenden Erfindung ist die Verwendung sogenannter "Nanotinte", in Kombination mit einer speziellen Sinterbehandlung, zur Erzeugung der Leiterstrukturen.

Wie vorstehend bereits erwähnt, bestehen Chipkarten und Laminatmaterialien mit elektronischen Schaltungseinheiten, die zur Integration in Chipkarten und andere Flachmaterialien, zum Beispiel Folientastaturen, geeignet sind, typischerweise aus Kunststoff-Folien, insbesondere aus heißlaminierbaren Kunststoff-Folien. Materialien sind beispielsweise Thermoplaste wie Polyester, Polycarbonate, Polyolefine, Polyamide, Polyimide, Fluorpolymere und Vinylpolymere, bevorzugt PVC. Bei der Ausbildung von leitenden Strukturen auf derartigen Folien ist zu beachten, dass die Folien bei Erwärmung mehr oder weniger stark erweichen und dabei ihre Form verlieren. Eine Verformung der Folien mit den Leiterstrukturen muss aber unbedingt vermieden werden, insbesondere da ansonsten Passerprobleme auftreten.

Ein bevorzugtes Verfahren zur Herstellung von Leiterstrukturen auf Folien für Kartenaufbauten besteht daher gegenwärtig darin, Leitpasten mit Metallpartikeln, beispielsweise mit Silberpartikeln, im Siebdruckverfahren in Form der gewünschten Leiterstrukturen auf die Folien aufzubringen, die Folien dann bei einer Temperatur bis maximal 50°C zu trocknen, typischerweise im Trockenkanal der Siebdruckanlage, und die getrockneten Folien mit Leiterstrukturen anschließend durch Heißlaminieren zu einem Laminatmaterial zu verbinden. In den fertigen Leiterstrukturen des Laminatmaterials liegen die Metallpartikel als Einzelpartikel, die einander kontaktieren, vor. Der elektrische Kontakt, und damit die Leitfähigkeit, zwischen einander kontaktierenden Einzelpartikeln ist erheblich schlechter, als dies bei einer kontinuierlichen Leiterstruktur der Fall wäre, beispielsweise bei einer aus einer massiven Metallschicht herausgeätzten Leiterstruktur. Um eine einigermaßen akzeptable Leitfähigkeit zu erzielen, müssen daher relativ dicke Leiterstrukturen ausgebildet werden. Ein hoher Materialverbrauch, und damit hohe Kosten, sind die Folge.

Erfindungsgemäß wurde nun gefunden, dass unter bestimmten Bedingungen eine Versinterung der Metallpartikel der Leitpasten, und damit eine erheblich bessere Leitfähigkeit, erzielt werden kann.

Erfindungsgemäß werden als Leitpasten Nanotinten verwendet. Nanotinten sind wässrige Suspensionen oder Suspensionen auf Lösemittelbasis von metallischen Partikeln, die Partikeldurchmesser im Bereich von einigen 10 nm haben, typischerweise 20 nm bis 1000 nm. Metallische Partikel sind Partikel aus Reinmetallen oder aus Metall-Legierungen, bevorzugt Silberpartikel, Aluminiumpartikel und Partikel aus Kupfer-Nickel-Legierungen. Der Gehalt an Nanopartikeln in den Suspensionen beträgt beispielsweise zwischen 10 bis 30 Gew.-%, wobei der Gehalt in erster Linie durch das gewünschte Auftragungsverfahren bestimmt wird. Geeignete Auftragungsverfahren sind insbesondere Druckverfahren, bevorzugt Siebdruck, Flexodruck, Aerosoldruck und Tintenstrahldruck. Besonders bevorzugt ist ein Siebdruckverfahren. Hierbei können relativ hohe Partikelkonzentrationen vorliegen, beispielsweise etwa 40 bis 60 Gew.-% metallische Nanopartikel.

Geeignete Nanotinten sind erhältlich von Bayer, beispielsweise die Nanosilber-Dispersion Bayink TP S mit einem Silbergehalt von 20 Gew.-% und die Nanosilber- und Nanoaluminium-Dispersionen von NovaCentrix. Die Standard-Nanosilber-Dispersionen haben Partikeldurchmesser von 25 nm beziehungsweise 35 nm. Es sind jedoch auch Dispersionen mit Partikelgrößen von 10 nm bis 100 nm erhältlich.

Die Nanopartikel haben die vorteilhafte Eigenschaft, dass sie bei wesentlich niedrigeren Temperaturen versinterbar sind als die Partikel konventioneller Leitpasten. Herkömmliche Leitpasten weisen beispielsweise eine mittlere Partikelgröße von 2µm auf, wobei es hier große Varianzen gibt. Unter "Sintern" ist ein oberflächliches Zusammenbacken der Einzelpartikel, gegebenenfalls unter oberflächlichem Anschmelzen, zu verstehen. Durch das Zusammenbacken wird der elektrische Kontakt, und damit die elektrische Leitfähigkeit gegenüber den einander lediglich kontaktierenden Einzelpartikeln erheblich verbessert. Es entsteht quasi ein Übergangszustand zwischen einander lediglich physisch kontaktierenden Einzelpartikeln und einer Leiterbahn aus massivem Material.

Silber-Nanopartikel versintern bei einer Temperatur von etwa 150°C. Diese Sintertemperatur der Nanopartikel ist jedoch immer noch viel zu hoch, um auf Kunststoff-Folien aufgedruckte Leiterstrukturen diesen Temperaturen aussetzen zu können. Die Folien würden sich dabei dramatisch verziehen oder sogar zersetzt werden. Die Zersetzung von handelsüblichen Folien beginnt beispielsweise schon bei 160°C.

Erfindungsgemäß erfolgt die Versinterung der Nanopartikel daher zu einem Zeitpunkt, zu dem die Kunststoff-Folien dergestalt fixiert sind, dass sie sich nicht verformen können, nämlich während des Heißlaminierens und gleichzeitig mit dem Heißlaminieren der Folien. Der Prozess des Heißlaminierens erfolgt unter erhöhtem Druck, beispielsweise bei 150-400 N/cm², und einer zur Versinterung der Nanopartikel ausreichenden Temperatur und Zeit, beispielsweise für 5-15 Minuten, wobei die zu laminierenden Folien in eine Laminierpresse eingespannt sind. Durch das Einspannen ist kein Verziehen der Folien möglich. Erhalten wird auf diese Weise ein Laminatmaterial mit aufgedruckten Leiterstrukturen, die gegenüber konventionellen aufgedruckten Leiterstrukturen eine wesentlich verbesserte Leitfähigkeit aufweisen. Bei den bevorzugten Silber-Nanopartikeln beträgt die Leitfähigkeit etwa 20% der Leitfähigkeit von massivem Silber, und unter günstigen Bedingungen können sogar noch höhere Leitfähigkeiten erzielt werden. Gleichzeitig kann eine Materialeinsparung von bis zu 50% gegenüber konventionellen SilberLeitpasten erzielt werden. Die erzeugten Leiterstrukturen können sehr flach sein, das heißt Dicken im Bereich von etwa 1 bis 25 µm, bevorzugt von etwa 5 bis 10 µm, haben.

Die auf diese Weise erzeugten Leiterstrukturen weisen noch weitere Vorteile auf. Beispielsweise haften sie hervorragend auf flexiblen Substraten, was insofern wichtig ist, da Karten während ihres Gebrauchs häufig gebogen werden, und auch bei sonstigen Einwirkungen auf das Kartenmaterial, wie mechanisches Eindrücken bleiben die Leiterstrukturen intakt. Außerdem zeigen die mittels Nanotinten erzeugten Leiterstrukturen geringe Kontaktwiderstände auf üblichen Bondpads aus Gold oder Platin, eignen sich also hervorragend zur Kontaktierung von IC-Chips. Leiterstrukturen in verschiedenen Ebenen können aus gleichen oder verschiedenen Materialien hergestellt werden.

Ein weiterer großer Vorteil ist, dass gesinterte Leiterbahnen mechanisch erheblich stabiler und belastbarer sind, als die herkömmlichen gedruckten Leiterbahnen. Dadurch wird die Gefahr des Reissens der Leiterbahnen während des Heißlaminiervorgangs deutlich reduziert, was besonders bei der zukunftsträchtigen FlipChip Technologie große Vorteile bringt.

Das Auftragen der Nanotinten auf die Kunststoff-Folien erfolgt durch Aufdrucken, bevorzugt mittels Siebdruck, Flexodruck, Aerosoldruck oder Tintenstrahldruck. Das bevorzugte Aufdruckverfahren ist der Siebdruck. Die Nanotinten enthalten flüssige Trägermedien, die vor dem Bedecken der Leiterstrukturen mit einer Folie und Verbinden zu einem Laminatmaterial entfernt werden sollten. Bei sehr flüchtigen Trägermedien kann die Zeit bis zur Weiterverarbeitung der bedruckten Folien ausreichend sein, dass das Trägermedium bei Raumtemperatur von selbst verdunstet, während es bei weniger flüchtigen Trägermedien, insbesondere wässrigen Trägermedien, in der Regel erforderlich ist, die bedruckte Folie vor dem Laminierungsprozess zu trocknen. Das Trocknen wird bei einer Temperatur durchgeführt, bei der keine Gefahr eines Verziehens der Folien besteht, also typischerweise bei einer Temperatur von etwa 40°C, maximal 50°C, und bei bestimmten Folien können auch etwas höhere Temperaturen von etwa 60°C angewendet werden.

Die Folien mit der darauf ausgebildeten Vorläufer-Leiterstruktur, d.h. der noch aus Einzelpartikeln bestehenden Leiterstruktur, wird nun mit einer weiteren Folie oder weiteren Folien zu einem Laminatmaterial heißlaminiert. Die weitere Folie beziehungsweise die weiteren Folien können ebenfalls Leiterstrukturen tragen, tragen aber nicht notwendigerweise derartige Leiterstrukturen. Bevorzugt werden zur Herstellung des Folienverbunds des Laminatmaterials ausschließlich heißlaminierbare Folien verwendet, aber es können grundsätzlich auch nicht heißlaminierbare Folien mit verwendet werden. Wenn die Folien für den durchgeführten Heißlaminierungsprozess einen zu hohen Erweichungspunkt haben, muss zwischen der entsprechenden Folie und der Nachbarfolie beziehungsweise den Nachbarfolien ein geeigneter Klebstoff vorgesehen werden, wie ein Heißschmelzklebstoff, so dass wie beim Heißlaminieren eine stoffschlüssige Verbindung zwischen den Folien erzeugt wird. Bevorzugt werden als Deckschichten des Folienverbundmaterials Folien auflaminiert oder aufkaschiert, die als Schutzschichten dienen, die Feuchtigkeitsbeständigkeit verbessern, oder statisch aufladbar sind. Die auflaminierten oder aufkaschierten Folien können auch mit elektronischen Bauteilen oder anderen Elementen bestückt werden. Alle Materialien können nach Wunsch lichtdurchlässig oder opak sein und gegebenenfalls gefärbt werden. Es versteht sich, dass alle Folien, die mit Leiterstrukturen in Kontakt sind, elektrisch isolierend sein müssen. Die einzelnen Folien brauchen sich nicht jeweils vollflächig über das gesamte Laminatmaterial zu erstrecken, müssen aber geeignete Abmessungen haben, um benachbarte Leiterstrukturen isolierend voneinander zu trennen. Elektrisch isolierend bedeutet in diesem Zusammenhang, dass die elektrische Leitfähigkeit derartiger Folien im Vergleich zu den Leiterstrukturen vernachlässigbar gering ist. Das Verhältnis der Leitwerte von Leiterstrukturen zu elektrisch isolierenden Folien sollte beispielsweise 1:1 Mio., bevorzugt 1:1Mrd., betragen.

Das Laminieren erfolgt bevorzugt in der Weise, dass die zu einem Folienverbund zu laminierenden Folien in der gewünschten Orientierung und Reihenfolge gestapelt und dann zwischen Laminierblechen einer Laminierpresse eingespannt werden. Im eingespannten Zustand wird unter erhöhtem Druck und bei einer Temperatur von etwa 130°C bis 150°C gleichzeitig die Verbindung der Folien zu einem Laminatmaterial und das Versintern der Vorläufer-Leiterstrukturen aus Einzelpartikeln zu quasi-kontinuierlichen Leiterstrukturen bewerkstelligt. Das Laminieren und Versintern kann mit Laminatmaterialien in den gewünschten Endabmessungen durchgeführt werden, wird jedoch bevorzugt an Bogenmaterialien mit einer Vielzahl von Einzelnutzen, die später auf die gewünschten Abmessungen zugeschnitten werden, durchgeführt. Die Laminierung kann in der Weise ausgeführt werden, dass sämtliche Folien des gewünschten Laminatmaterials in einem Arbeitsgang zu einem Folienverbund laminiert werden oder dass zwei oder mehr Teil-Folienverbundmaterialien hergestellt werden, die dann in einem weiteren Arbeitsgang zu dem gewünschten Laminatmaterial laminiert beziehungsweise kaschiert werden.

Die erhaltenen Laminatmaterialien können bereits fertige Karten sein, sind aber typischerweise Inletts, die in einen Kartenaufbau zu integrieren sind. Wenn ein Inlett dieselben Abmessungen wie die Karte selbst hat, erstreckt es sich über die gesamte Fläche der Karte, und es treten im Kartenaufbau keine Dickenschwankungen auf. Es ist daher bevorzugt, die erfindungsgemäßen Laminatmaterialien in den Abmessungen der Karte oder des sonstigen Flachmaterialelements, in das sie integriert werden sollen, herzustellen.

Die erfindungsgemäßen Laminatmaterialien mit Leiterstrukturen können in an sich bekannter Weise mit elektronischen Funktionselementen kombiniert werden und dann beispielsweise elektronische Schaltungseinheiten zur kontaktlosen Datenübermittlung oder Folientastaturen bilden. Insbesondere können Leiterstrukturen in einer oder in mehreren Schichten hergestellt werden, die in einer Schaltungseinheit zur kontaktlosen Datenübermittlung als Antennen wirken, oder die einen Schalter bilden und elektronische Funktionselemente in der gleichen oder in verschiedenen Ebenen eines Laminatmaterials an- beziehungsweise abschalten.

Der Aufbau derartiger Schaltungseinheiten ist hinsichtlich Materialien (selbstverständlich abgesehen von der Verwendung von Nanotinten und des kombinierten Laminier-/Sinterprozesses), hinsichtlich der erforderlichen Schichtaufbauten, gegebenenfalls hinsichtlich einer Durchkontaktierung zwischen den Schichten, und hinsichtlich der Verbindung mit elektronischen Funktionselementen an sich konventionell. Es wird diesbezüglich insbesondere auf die europäische Patentanmeldung 0 756 244 A2 verwiesen.

Die Erfindung wird nachfolgend anhand von Figuren noch weiter veranschaulicht. Es wird darauf hingewiesen, dass die Figuren nicht maßstabs- und nicht proportionsgetreu sind. Ferner sind die in einer Figur dargestellten Merkmale nicht nur in Kombination mit den übrigen in der entsprechenden Figur dargestellten Merkmalen anwendbar. Vielmehr können im Zusammenhang mit einer speziellen Ausführungsform beschriebene Merkmale ganz allgemein bei dem erfindungsgemäßen Laminatmaterial zur Anwendung kommen. Gleiche Bezugsziffern bezeichnen gleiche oder entsprechende Elemente. Es zeigen:
- Fig. 1: ein erfindungsgemäßes Laminatmaterial in Aufsicht,
- Fig. 2: eine erfindungsgemäße Chipkarte in Aufsicht,
- Fig. 3: die Chipkarte von Fig. 2 in perspektivischer Sicht,
- Fig. 4: einen Querschnitt entlang der Linie A-A der Fig. 3,
- Fig. 5, 6: Beispiele für die Orientierung von Spulenlagen und für die Durchkontaktierung zur Herstellung einer leitenden Verbindung zwischen gegenüberliegenden Spulenlagen im Querschnitt,
- Fig. 7: eine Teilschnittansicht eines erfindungsgemäßen Laminatmaterials mit einem Schalter als Explosionsdarstellung,
- Fig. 8a, 9a: jeweils Aufsichten von unten auf eine Leiterstruktur des Schalters, und
- Fig. 8b, 9b: jeweils Aufsichten von oben auf der Leiterstruktur von Fig. 8a, 9a gegenüberliegende Leiterstrukturen des Schalters.

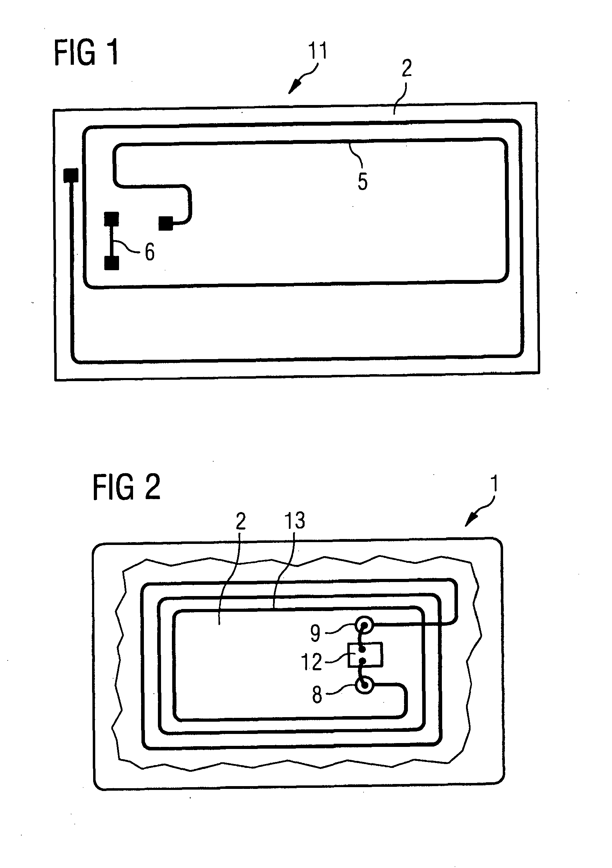

Fig. 1 zeigt ein erfindungsgemäßes Laminatmaterial 11 in Aufsicht. Das Laminatmaterial 11 weist eine erste Folienschicht 2 und eine zweite Folienschicht 3 auf, wobei die zweite Folienschicht 3 transparent ist, so dass die erste Leiterstruktur 5 und die zweite Leiterstruktur 6 zwischen den Folienschichten erkennbar sind, wobei die Leiterstruktur 5 mit der Leiterstruktur 6 verbunden ist, beispielsweise ist die Leiterstruktur 6 mit dem linken Ende der Leiterstruktur 5 verbunden. Die Enden der Leiterstrukturen 5,6 zum Verbinden mit einem elektronischen Funktionselement, wie einem IC-Chip, sind jeweils verbreitert dargestellt. Die IC-Chips selbst sind in der schematischen Darstellung weggelassen. Die erste Leiterstruktur 5 ist eine Leiterbahn in Form einer Spule, wie sie für Datenträger zum kontaktlosen Datenaustausch oder zur kontaktlosen Energieversorgung benötigt wird. Zur Herstellung des Laminatmaterials 11 wird eine Nanotinte, beispielsweise eine Suspension mit Silber-Nanopartikeln, auf eine Oberfläche der Folie 2 aufgedruckt, beispielsweise im Siebdruckverfahren. Die Nanotinte wird jeweils in einer Gestalt aufgetragen, die der Gestalt der gewünschten Leiterstrukturen 5,6 entspricht. Dabei werden Vorläufer-Leiterstrukturen ausgebildet, die aus Einzel-Nanopartikeln bestehen. Die Folie 2 mit den Vorläufer-Leiterstrukturen wird nun getrocknet, beispielsweise bei etwa 40°C, und dann an der Oberfläche, auf der sich die Vorläufer-Leiterstrukturen befinden, mit einer durchsichtigen Folie 3 bedeckt. Die erste Folie 2 und die zweite Folie 3 werden nun gemeinsam zwischen Laminierblechen in einer Laminierpresse fest eingespannt und bei einer Temperatur, die zum Heißlaminieren der ernsten Folie 2 und der zweiten Folie 3 sowie zum Versintern der Silber-Nanopartikel ausreichend ist, bevorzugt etwa 150°C, einem kombinierten Heißlaminierungs-/Sinterprozess unterzogen. Dabei entsteht aus der ersten Vorläufer-Leiterstruktur die erste Leiterbahn 5, und aus der zweiten Vorläufer-Leiterstruktur die zweite Leiterbahn 6, jeweils eingeschlossen in dem Laminatmaterial 11 aus den Folien 2, 3.

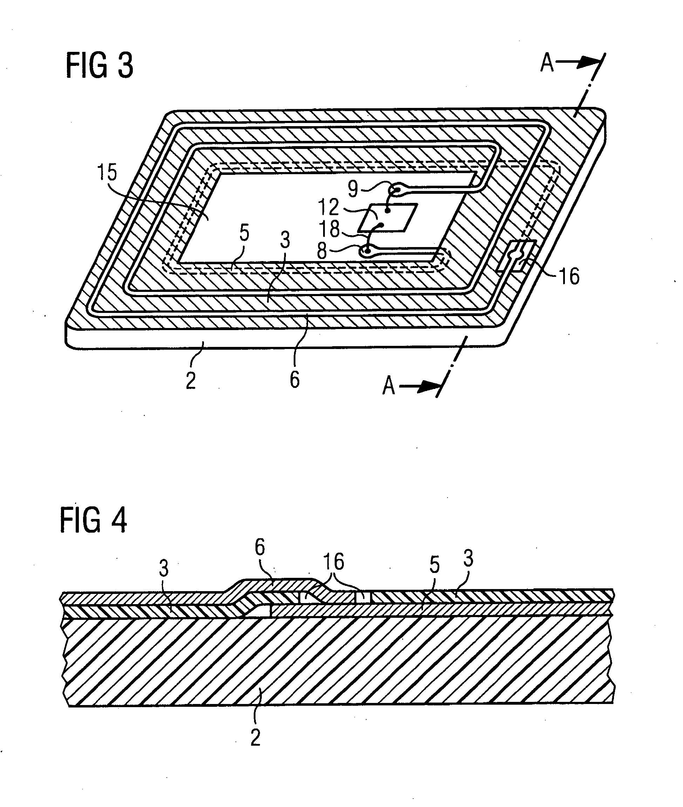

Die Figuren 2 und 3 zeigen eine Chipkarte 1 in Aufsicht beziehungsweise in perspektivischer Sicht. Die Chipkarte 1 weist ebenfalls eine Spule auf, wie die durch die erste Leiterstruktur 5 gebildete Spule in Fig. 1. Die Spule 13 der Chipkarte 1 besteht jedoch aus zwei Spulenlagen, die durch eine isolierende Folienschicht getrennt werden. Die Chipkarte 1 weist eine erste Folienschicht 2, eine zweite Folienschicht 3 und eine dritte Folienschicht, die in Fig. 2 und 3 nicht dargestellt ist, auf. Die Folienschichten sind jeweils elektrisch isolierende Kunststoff-Folien. Zwischen der ersten Folienschicht 2 und der zweiten Folienschicht 3 befindet sich die erste Leiterstruktur 5, die eine erste Spulenlage bildet, und zwischen der zweiten Folienschicht 3 und der dritten Folienschicht befindet sich eine zweite Leiterstruktur 6, die eine zweite Spulenlage bildet. Die zweite Folienschicht 3 weist durchgehende Öffnungen 15, 16 auf. Die Öffnung 16 dient dazu, die erste Leiterstruktur 5 und die zweite Leiterstruktur 6 elektrisch leitend miteinander zu verbinden, wie noch genauer bei Fig. 4 erläutert wird. Dadurch entsteht die "zweilagige" Spule 13. Das Kontaktfenster 16 in der Zwischenschicht 3 kann jedoch auch entfallen. Dann besteht zwischen den beiden Spulenlagen keine elektrisch leitende Verbindung. Die Spulenlagen sind stattdessen kapazitiv gekoppelt.

Die durchgehende Öffnung 15 im mittigen Bereich der Folienschicht 3 dient dazu, eine elektrisch leitende Verbindung zwischen den Enden 8, 9 der Spule 13 und einem IC-Chip 12 herzustellen. Insbesondere befindet sich das Ende 8 der ersten Leiterstruktur 5 auf der ersten Folienschicht 2, und es würde von einer Folienschicht 3 ohne durchgehende Öffnung 15 abgedeckt werden. Bei der dargestellten Ausführungsform sind die Abmessungen der zweiten Folienschicht beziehungsweise der Zwischenschicht 3 so gewählt, dass die zweite Folienschicht 3 lediglich die erste Leiterstruktur 5 und die zweite Leiterstruktur 6 voneinander isoliert, den mittigen Bereich der ersten Folienschicht 2 aber nicht bedeckt. Der IC-Chip 12 befindet sich in der dargestellten Ausführungsform dementsprechend auf einer Oberfläche der ersten Folienschicht 2. Er ist in an sich bekannter Weise über Bonddrähtchen 18 mit dem ersten Leiterstrukturende 8 und dem zweiten Leiterstrukturende 9 verbunden. Alternativ kann allerdings auch die zweite Folienschicht 3 vollflächig ausgebildet werden. In diesem Fall ist auch der integrierte Schaltkreis 12 kapazitiv an die Spule 13 gekoppelt, analog der kapazitiven Kopplung der ersten und der zweiten Spulenlage bei Fehlen des Kontaktfensters 16.

Die Herstellung der Chipkarte 1 erfolgt durch Aufdrucken einer ersten Vorläufer-Leiterstruktur auf eine Oberfläche der ersten Folie 2 mittels einer Nanotinte, Aufdrucken einer zweiten Vorläufer-Leiterstruktur auf eine Oberfläche der zweiten Folie 3, Stapeln der ersten Folie, der zweiten Folie und einer dritten Folie in der angegebenen Reihenfolge, und Heißlaminieren der Folien zu einem Verbundmaterial beziehungsweise Laminatmaterial. Die Folien 2 und 3 müssen natürlich so gestapelt werden, dass die Folie 3 die Leiterstrukturen 5 und 6 voneinander trennt. Beim Heißlaminieren versintern gleichzeitig die Einzel-Nanopartikel der Vorläufer-Leiterstrukturen zu der ersten Leiterstruktur 5 und der zweiten Leiterstruktur 6, und, falls ein Kontaktfenster 16 vorhanden ist, bildet sich auch die elektrisch leitende Verbindung zwischen den Leiterstrukturen 5, 6 aus.

Fig. 4 zeigt einen Querschnitt entlang der Linie A-A der Fig. 3. Der Querschnitt verdeutlicht zum einen den Schichtaufbau der Chipkarte und die elektrisch leitende Verbindung zwischen den Spulenlagen 5, 6 durch das Kontaktfenster 16 der Zwischenschicht 3, und zum anderen verdeutlicht Fig. 4 eine alternative Herstellungsvariante des Laminatmaterials der Chipkarte 1. Bei dieser Herstellungsvariante wird die Vorläufer-Leiterstruktur der ersten Leiterstruktur 5 auf eine Oberfläche der ersten Folienschicht 2 aufgedruckt, dann bei moderater Temperatur, beispielsweise 40°C getrocknet, und mit der zweiten Folie 3 bedeckt. Auf die freie Oberfläche der zweiten Folie 3 wird dann die Vorläufer-Leiterstruktur der zweiten Leiterstruktur 6 aufgedruckt und wiederum getrocknet. Außerdem wird der IC-Chip 12 aufgesetzt und mit den Enden der Vorläufer-Leiterstrukturen verbunden. Schließlich wird der Stapel noch mit einer dritten Folie bedeckt, der Stapel aus den Folien 2, 3, 4 in eine Laminierpresse eingespannt und zu einem Laminatmaterial heißlaminiert. Dabei bilden sich wiederum gleichzeitig die erste Leiterstruktur 5 und die zweite Leiterstruktur 6.

Anstelle der abdeckenden Folienschicht könnte auch eine weitere "Zwischenschicht" aufgelegt werden, d.h. eine Schicht, auf die wiederum eine Vorläufer-Leiterstruktur aufgedruckt wird. Dieser schichtweise Aufbau kann rein prinzipiell beliebig lange fortgesetzt werden.

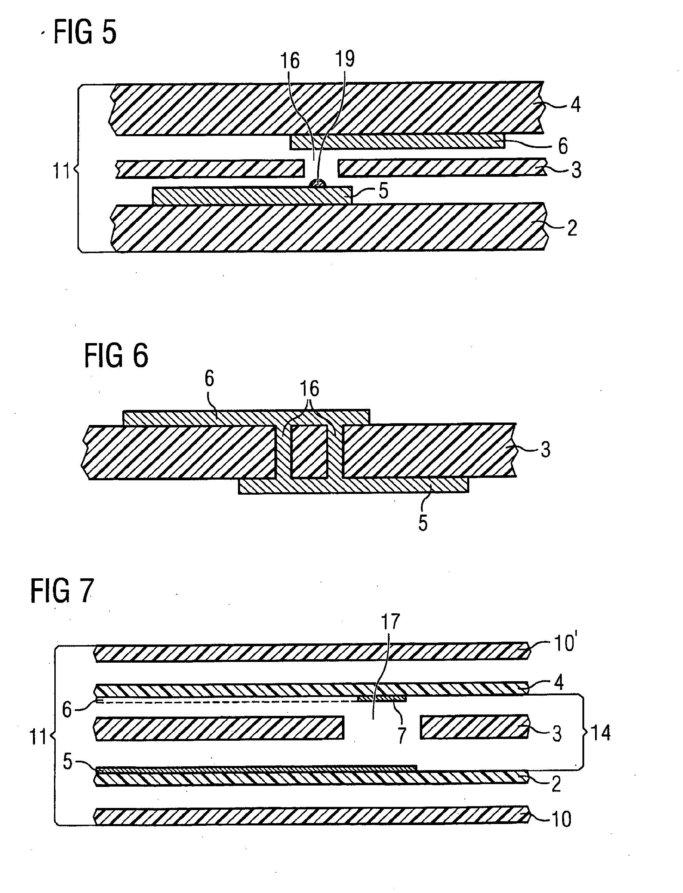

Weitere Varianten für Auftragungsarten der Vorläufer-Leiterstrukturen sind in den Figuren 5 und 6 dargestellt. Bei der in Fig. 5 dargestellten Variante wird die Vorläufer-Leiterstruktur der ersten Leiterstruktur 5 auf eine Oberfläche der ersten Folie 2 aufgedruckt, und die Vorläufer-Leiterstruktur der zweiten Leiterstruktur 6 wird auf eine Oberfläche einer dritten Folie 4 aufgedruckt. Die Folien 2 und 4 werden unter Zwischenlegung einer zweiten Folie 3 so aufeinander gelegt, dass die Vorläufer-Leiterstrukturen zueinander weisen und durch ein Kontaktfenster 16 in der Folienschicht 3 miteinander elektrisch leitend verbunden werden können. Eine kleine Menge Leitkleber 19, die beim Laminieren in das Fenster 16 fließt, erleichtert die Herstellung einer elektrisch leitenden Verbindung zwischen den Leiterstrukturen 5, 6. Alternativ kann auf den Leitkleber 19 verzichtet werden. Der Schichtstapel wird, gegebenenfalls nach vorherigem Trocknen der Vorläufer-Leiterstrukturen bei moderater Temperatur, in eine Laminierpresse eingespannt und heißlaminiert. Dabei bildet sich nicht nur das Laminatmaterial 11, sondern es erfolgt gleichzeitig die Versinterung der Nanopartikel der Vorläufer-Leiterstrukturen zu den quasi-kontinuierlichen Leiterstrukturen 5, 6.

Bei der in Fig. 6 dargestellten Variante werden die Vorläufer-Leiterstrukturen der ersten Leiterstruktur 5 und der zweiten Leiterstruktur 6 auf verschiedene Oberflächen derselben Folie aufgedruckt. Diese Folie 3 weist bei der dargestellten Ausführungsform zwei durchgehende Öffnungen (Kontaktfenster) 16 auf, die beim Aufdrucken der Vorläufer-Leiterstrukturen mit Nanotinte gefüllt werden. Anschließend werden beide Oberflächen der Folie 3, gegebenenfalls nach Trocknen der Vorläufer-Leiterstrukturen bei moderater Temperatur, mit weiteren Folien bedeckt, d.h. die weiteren Folien sollten zumindest die Vorläufer-Leiterstrukturen bedecken. Anschließend wird wiederum der Folienstapel in einer Laminierpresse heißlaminiert, wobei die Versinterung der Nanopartikel der Nanotinte stattfindet, und wobei die endgültigen Leiterstrukturen 5, 6 ausgebildet werden, die durch die Leiterstrukturen in den Öffnungen 16 elektrisch leitend verbunden sind.

Die dargestellten Ausführungsformen weisen jeweils nur drei Folienschichten auf. Es können aber selbstverständlich weitere Folienschichten auflaminiert oder aufkaschiert werden, wobei diese weiteren Folienschichten ebenfalls elektrisch leitfähige Leiterstrukturen aufweisen können, die gemäß dem erfindungsgemäßen Verfahren durch Aufdrucken von Nanotinten hergestellt werden. Diese weiteren Folien können gleichzeitig mit den übrigen Folienschichten heißlaminiert werden, oder das Heißlaminieren kann in mehreren Schritten, d.h. an Teil-Folienstapeln, durchgeführt werden. Beim Heißlaminieren in mehreren Schritten erfolgt auch das Versintern der Vorläufer-Leiterstrukturen zu den endgültigen Leiterstrukturen in mehreren Schritten.

Die dargestellten Laminatmaterialien mit Leiterstrukturen aus versinterten metallischen Nanopartikeln, kombiniert mit einem elektronischen Funktionselement oder mehreren elektronischen Funktionselementen, werden typischerweise als Inletts in den Schichtaufbau einer Karte integriert. Alternativ kann auch bereits der endgültige Kartenaufbau in der angegebenen Weise hergestellt werden.

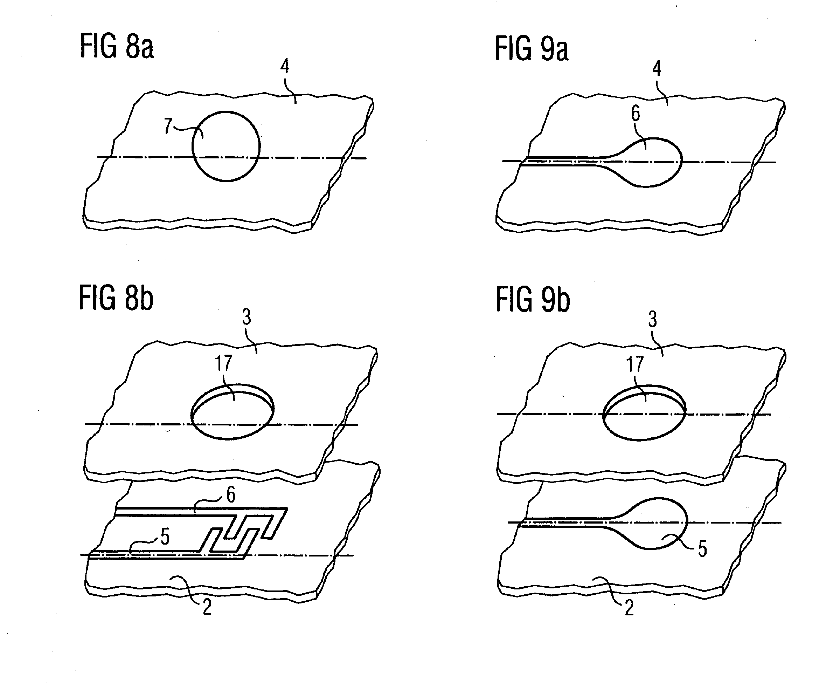

Fig. 7 zeigt eine Teilschnittansicht eines erfindungsgemäßen Laminatmaterials 11 mit einem Schalter 14. Die Folienschichten sind im Zustand vor dem Laminieren, aber in der erforderlichen Schichtfolge und Orientierung zueinander, dargestellt. Das Laminatmaterial 11 weist eine erste Folie 2, eine zweite Folie 3 und eine dritte Folie 4, sowie weitere Folienschichten 10,10' auf. Auf einer Oberfläche der Folie 2 befindet sich eine mittels Nanotinte aufgedruckte Vorläufer-Leiterstruktur einer ersten Leiterstruktur 5. Auf einer Oberfläche der Folie 4 befindet sich eine ebenfalls mittels Nanotinte aufgedruckte Vorläufer-Leiterstruktur einer weiteren Leiterstruktur, die verschiedene Gestalten haben kann, wie in Fig. 8a und Fig. 9a gezeigt. Fig. 8a zeigt eine Leiterstruktur 7 in Form einer Leitfläche ohne irgendeine Verbindung zu Leiterbahnen, und Fig. 9a zeigt eine Leiterstruktur 6, die eine Kombination aus Leitfläche und Leiterbahn ist. In Fig. 7 ist die Leiterstruktur 7 mit durchgehenden Linien gezeichnet, während die Leiterstruktur 6 mit gestrichelten Linien als Verlängerung der Leiterstruktur 7 dargestellt ist.

Die Figuren 8a, 9a zeigen jeweils Aufsichten von unten auf die Leiterstrukturen 7 beziehungsweise 6. Die Figuren 8b und 9b zeigen jeweils Aufsichten von oben auf die den Leiterstrukturen 7 beziehungsweise 6 gegenüberliegenden Leiterstrukturen, die sich an einer Oberfläche der Folie 2 befinden. In den Figuren 8b, 9b ist jeweils auch die Zwischenschicht 3 dargestellt, die die Leiterstrukturen auf den Folien 2 und 4, den "Kontaktfolien", voneinander trennt, jedoch eine durchgehende Öffnung 17 aufweist, durch die die gegenüberliegenden Leiterstrukturen miteinander in Kontakt kommen können. Der Kontakt wird durch Ausübung eines Drucks auf die elastischen Kontaktfolien des Laminatmaterials 11 im Bereich der durchgehenden Öffnung 17 (des Schaltfensters 17) hergestellt, und durch Beenden des Druck wieder unterbrochen. Wenn kein Druck mehr ausgeübt wird, kehren die elastischen Folien wieder in ihren Ausgangszustand zurück. Mit dieser Anordnung können elektronische Funktionselemente an- und abgeschaltet werden. Je nachdem, ob ein Kontakt zwischen verschiedenen Ebenen des Laminatmaterials hergestellt beziehungsweise unterbrochen werden soll, oder ob ein Kontakt in derselben Ebene hergestellt oder unterbrochen werden soll, sind die Leiterstrukturen unterschiedlich gestaltet.

Fig. 8 betrifft die Herstellung/Unterbrechung eines elektrischen Kontakts zwischen Leiterstrukturen in derselben Ebene. Eine erste Leiterstruktur 5 und eine zweite Leiterstruktur 6 (Fig. 8b) können mittels einer dritten Leiterstruktur 7 (Fig. 8a) elektrisch leitend miteinander verbunden werden.

Fig. 9 betrifft die Herstellung/Unterbrechung eines elektrischen Kontakts zwischen Leiterstrukturen in verschiedenen Ebenen. Eine erste Leiterstruktur 5 (Fig. 9b) kann mit einer zweiten Leiterstruktur 6 (Fig. 9a) elektrisch leitend verbunden werden. Die Leiterstrukturen 5, 6 und 7 (Fig. 8) und die Leiterstrukturen 5 und 6 (Fig. 9) bilden jeweils zusammen einen Schalter 14.

Die Herstellung eines derartigen Laminatmaterials 11 mit einem Schalter 14 erfolgt wiederum durch Aufdrucken von Vorläufer-Leiterstrukturen mittels Nanotinten auf die Oberflächen von entsprechenden Folien, gegebenenfalls Trocknen der Vorläufer-Leiterstrukturen bei moderater Temperatur, Stapeln der Folienschichten in der passenden Reihenfolge und Orientierung zueinander, und Heißpressen des Folienstapels, wobei gleichzeitig das Laminatmaterial 11 gebildet wird und die Einzel-Nanopartikel der Vorläufer-Leiterstrukturen zu den Leiterstrukturen 5 und 6, beziehungsweise 5, 6, 7, versintert werden.

Laminatmaterialien, wie das in Fig. 7 dargestellte, sind beispielsweise zur Herstellung von Folientastaturen geeignet.

Selbstverständlich können in den Laminatmaterialien auch mehrere Funktionen miteinander kombiniert werden. Beispielsweise können Leiterbahnen unterschiedlichster Formen, ein- oder mehrschichtige Spulen, und Schalter in ein und demselben Laminatmaterial enthalten sein.

## Patentansprüche

1. Verfahren zur Herstellung eines Laminatmaterials (11), das mindestens eine erste Folienschicht (2), eine der ersten Folienschicht benachbarte zweite Folienschicht (3) und mindestens eine elektrisch leitfähige Leiterstruktur (5) zwischen der ersten und der zweiten Folienschicht aufweist, wobei die erste und die zweite Folienschicht elektrisch isolierend und heißlaminierbar sind, **gekennzeichnet durch** folgende Schritte:
(a) Auftragen einer metallische Nanopartikel enthaltenden Dispersion in Form der mindestens einen Leiterstruktur (5) auf eine Oberfläche der ersten Folienschicht (2) zur Erzeugung einer von den Nanopartikeln gebildeten Vorläufer-Leiterstruktur,
(b) Bedecken der ersten Folienschicht (2) mindestens teilweise mit der zweiten Folienschicht (3) dergestalt, dass die von den Nanopartikeln gebildete Vorläufer-Leiterstruktur mindestens teilweise von der zweiten Folienschicht (3) bedeckt wird, und
(c) Heißlaminieren der ersten und der zweiten Folienschicht (2,3) und gleichzeitig Versintern der die Vorläufer-Leiterstruktur bildenden metallischen Nanopartikel zu der elektrisch leitfähigen Leiterstruktur (5).

2. Verfahren nach Anspruch 1, **dadurch gekennzeichnet, dass** es außerdem folgende Schritte aufweist:
Auftragen einer metallische Nanopartikel enthaltenden Dispersion in Form einer zweiten Leiterstruktur (6) auf eine Oberfläche der zweiten Folienschicht (3) zur Erzeugung einer von den Nanopartikeln gebildeten zweiten Vorläufer-Leiterstruktur,
Bedecken der zweiten Folienschicht (3) mindestens teilweise mit einer dritten Folienschicht (4) dergestalt, dass die von den Nanopartikeln gebildete zweite Vorläufer-Leiterstruktur mindestens teilweise von der dritten Folienschicht (4) bedeckt wird, und
Heißlaminieren der ersten, zweiten und dritten Folienschicht (2, 3, 4) zu dem Laminatmaterial (11), in dem die zweite Folienschicht (3) zwischen der ersten und der zweiten Vorläufer-Leiterstruktur angeordnet ist, und gleichzeitig Versintern der die Vorläufer-Leiterstrukturen bildenden metallischen Nanopartikel zu der elektrisch leitfähigen ersten Leiterstruktur (5) und der elektrisch leitfähigen zweiten Leiterstruktur (6).

3. Verfahren nach Anspruch 2, **dadurch gekennzeichnet, dass** es außerdem folgende Schritte aufweist:
Auftragen einer metallische Nanopartikel enthaltenden Dispersion in Form einer dritten Leiterstruktur (7) auf eine Oberfläche der dritten Folienschicht (4) zur Erzeugung einer von den Nanopartikeln gebildeten dritten Vorläufer-Leiterstruktur,
Bedecken der dritten Folienschicht (4) mindestens teilweise mit einer weiteren Folienschicht (10') dergestalt, dass die von den Nanopartikeln gebildete dritte Vorläufer-Leiterstruktur mindestens teilweise von der weiteren Folienschicht (10') bedeckt wird, und
Heißlaminieren der ersten, zweiten, dritten und vierten Folienschicht (2,3,4,10') zur dem Laminatmaterial (11), in dem die zweite Folienschicht (3) zwischen der ersten und der zweiten Vorläufer-Leiterstruktur angeordnet ist, und die dritte Folienschicht (4) zwischen der zweiten und der dritten Vorläufer-Leiterstruktur angeordnet ist, und gleichzeitig Versintern der die Vorläufer-Leiterstrukturen bildenden metallischen Nanopartikel zu der ersten, zweiten und dritten Leiterstruktur (5, 6, 7).

4. Verfahren nach Anspruch 1, **dadurch gekennzeichnet, dass** es außerdem folgende Schritte aufweist:
Auftragen einer metallische Nanopartikel enthaltenden Dispersion in Form einer zweiten Leiterstruktur (6) auf die andere Oberfläche der ersten Folienschicht (2) zur Erzeugung einer von den Nanopartikeln gebildeten zweiten Vorläufer-Leiterstruktur,
Bedecken der ersten Folienschicht (2) mindestens teilweise mit einer dritten Folienschicht (4) dergestalt, dass die von den Nanopartikeln gebildete zweite Vorläufer-Leiterstruktur mindestens teilweise von der dritten Folienschicht (4) bedeckt wird, und
Heißlaminieren der ersten, der zweiten und der dritten Folienschicht (2,3,4) zu dem Laminatmaterial (11), in dem die erste Folienschicht (2) zwischen der ersten und der zweiten Vorläufer-Leiterstruktur angeordnet ist, und gleichzeitig Versintern der die Vorläufer-Leiterstrukturen bildenden metallischen Nanopartikel zu der elektrisch leitfähigen ersten und zweiten Leiterstruktur (5, 6).

5. Verfahren nach Anspruch 1, **dadurch gekennzeichnet, dass** es außerdem folgende Schritte aufweist:
Auftragen einer metallische Nanopartikel enthaltenden Dispersion in Form einer zweiten Leiterstruktur (6) auf eine Oberfläche einer dritten Folienschicht (4) zur Erzeugung einer von den Nanopartikeln gebildeten zweiten Vorläufer-Leiterstruktur,
Bedecken der ersten Folienschicht (2) und der dritten Folienschicht (4) mindestens teilweise mit der zweiten Folienschicht (3) dergestalt, dass die von den Nanopartikeln gebildete erste und zweite Vorläufer-Leiterstruktur jeweils mindestens teilweise von der zweiten Folienschicht (3) bedeckt wird, und
Heißlaminieren der ersten, der zweiten und der dritten Folienschicht (2,3,4) zu dem Laminatmaterial (11), in dem die zweite Folienschicht (3) zwischen der ersten und der zweiten Vorläufer-Leiterstruktur angeordnet ist, und gleichzeitig Versintern der die ersten und die zweite Vorläufer-Leiterstruktur bildenden metallischen Nanopartikel zu der elektrisch leitfähigen ersten und zweiten Leiterstruktur (5, 6).

6. Verfahren nach einem der Ansprüche 2 bis 5, **dadurch gekennzeichnet, dass** in den Folienschichten (2, 3, 4), die benachbarte Leiterstrukturen (5, 6, 7) voneinander trennen, Kontaktfester (16) zur Herstellung einer elektrisch leitenden Verbindung zwischen benachbarten Leiterstrukturen ausgebildet werden.

7. Verfahren nach Anspruch 1, **dadurch gekennzeichnet, dass** es außerdem folgende Schritte aufweist:
Auftragen einer metallische Nanopartikel enthaltenden Dispersion in Form einer ersten und einer zweiten Leiterstruktur (5, 6) auf eine Oberfläche der ersten Folienschicht (2) zur Erzeugung einer von den Nanopartikeln gebildeten ersten und zweiten Vorläufer-Leiterstruktur, und Auftragen einer metallische Nanopartikel enthaltenden Dispersion in Form einer dritten Leiterstruktur (7) auf eine Oberfläche einer dritten Folienschicht (4) zur Erzeugung einer von den Nanopartikeln gebildeten dritten Vorläufer-Leiterstruktur,
Bedecken der ersten Folienschicht (2) und der dritten Folienschicht (4) mit einer zweiten Folienschicht (3), die eine durchgehende Öffnung (17) aufweist, dergestalt, dass die erste und die zweite Vorläufer-Leiterstruktur im Wesentlichen von der zweiten Folienschicht (3) bedeckt werden, und dass im Bereich der Öffnung (17) die erste und zweite Vorläufer-Leiterstruktur der dritten Vorläufer-Leiterstruktur überlappend angeordnet sind und nicht von der zweiten Folienschicht (3) bedeckt werden, und
Heißlaminieren der ersten, der zweiten und der dritten Folienschicht (2, 3, 4) zu dem Laminatmaterial (11), in dem die zweite Folienschicht (3) zwischen der ersten und der zweiten Vorläufer-Leiterstruktur einerseits, und der dritten Vorläufer-Leiterstruktur andererseits, angeordnet ist, und gleichzeitig Versintern der die erste, zweite, und dritte Vorläufer-Leiterstruktur bildenden metallischen Nanopartikel zu der ersten, zweiten, und dritten elektrisch leitfähigen Leiterstruktur (5, 6, 7).

8. Verfahren nach Anspruch 1, **dadurch gekennzeichnet, dass** es außerdem folgende Schritte aufweist:
Auftragen einer metallische Nanopartikel enthaltenden Dispersion in Form einer zweiten Leiterstruktur (6) auf eine Oberfläche einer dritten Folienschicht (4) zur Erzeugung einer von den Nanopartikeln gebildeten zweiten Vorläufer-Leiterstruktur,
Bedecken der ersten Folienschicht (2) und der dritten Folienschicht (4) mit einer zweiten Folienschicht (3), die eine durchgehende Öffnung (17) aufweist, dergestalt, dass die erste und die zweite Vorläufer-Leiterstruktur im Wesentlichen von der zweiten Folienschicht (3) bedeckt werden, und im Bereich der Öffnung (17) einander überlappend angeordnet sind und nicht von der zweiten Folienschicht (3) bedeckt werden, und
Heißlaminieren der ersten, der zweiten und der dritten Folienschicht (2, 3, 4) zu dem Laminatmaterial (11), in dem die zweite Folienschicht (3) zwischen der ersten und der zweiten Vorläufer-Leiterstruktur angeordnet ist, und gleichzeitig Versintern der die erste und die zweite Vorläufer-Leiterstruktur bildenden metallischen Nanopartikel zu der ersten und der zweiten elektrisch leitfähigen Leiterstruktur (5, 6).

9. Verfahren nach einem der Ansprüche 1 bis 8, **dadurch gekennzeichnet, dass** das Heißlaminieren bei einer Temperatur von 130°C bis 150°C durchgeführt wird, während die Folienschichten (2,3,4, 10) in einer Laminierpresse fixiert sind.

10. Verfahren nach einem der Ansprüche 1 bis 9, **dadurch gekennzeichnet, dass** die Vorläufer-Leiterstrukturen vor dem Bedecken mit einer Folienschicht (3, 4, 10) bei einer Temperatur von bis zu 60°C, bevorzugt bis zu 50°C, getrocknet werden.

11. Verfahren nach einem der Ansprüche 1 bis 10, **dadurch gekennzeichnet, dass** die Nanopartikel enthaltenden Dispersionen wässrige Dispersionen oder Dispersionen auf Lösemittelbasis mit einem Gehalt an Nanopartikeln von 10 Gew.-% bis 30 Gew.-% und/oder mit einem mittleren Partikeldurchmesser der Nanopartikel von 20 nm bis 1000 nm sind, wobei die Nanopartikel Partikel aus Reinmetallen oder aus Metall-Legierungen sind und bevorzugt ausgewählt werden aus der Gruppe, die aus Silber, Aluminium und Kupfer-Nickel-Legierungen besteht.

12. Verfahren nach einem der Ansprüche 1 bis 11, **dadurch gekennzeichnet, dass** das Auftragen der metallische Nanopartikel enthaltenden Dispersion durch ein Druckverfahren erfolgt, bevorzugt durch ein Druckverfahren, das ausgewählt wird aus der Gruppe, die aus Siebdruck, Flexodruck, Aerosoldruck und Tintenstrahldruck besteht.

13. Verfahren zur Herstellung eines Laminatmaterials (11) nach Anspruch 1, **dadurch gekennzeichnet, dass** es mindestens ein Funktionselement, wie einen IC-Chip (12), aufweist, und dass die mindestens eine Leiterstruktur (5, 6, 7) eine Spule (13) bildet.

14. Verfahren zur Herstellung eines Laminatmaterials (11) nach Anspruch 1, **dadurch gekennzeichnet, dass** es mindestens ein Funktionselement, wie einen IC-Chip (12), und mindestens zwei Leiterstrukturen (5, 6, 7) aufweist, wobei die Leiterstrukturen eine Spule (13) oder einen Schalter (14) bilden.

15. Verfahren zur Herstellung einer Chipkarte (1) oder eines Chipkarten-Inletts, aufweisend eine Mehrzahl von durch Heißlaminieren verbundenen Folienschichten (2,3,4,10,10') und eine elektronische Schaltungseinheit mit mindestens einem IC-Chip (12) und mindestens einer Spule (13) und/ oder mindestens einem Folienschalter (14), **dadurch gekennzeichnet, dass** die Leiterstruktur der Spule und/ oder des Folienschalters aus versinterten metallischen Nanopartikeln besteht und nach einem Verfahren gemäß einem der Ansprüche 1 bis 12 erhältlich ist.

16. Verfahren zur Herstellung einer Chipkarte (1) nach Anspruch 15, **dadurch gekennzeichnet, dass** sie ein kontaktloser Datenträger ist.

## Claims

1. A method for manufacturing a laminate material (11) having at least a first foil layer (2), a second foil layer (3) adjacent to the first foil layer, and at least an electroconductive conductor structure (5) between the first and the second foil layer, wherein the first and the second foil layer are electrically insulating and hot-laminatable, **characterized by** the following steps of:
(a) applying, in the form of at the least one conductor structure (5), a dispersion containing metallic nanoparticles to a surface of the first foil layer (2) to produce a precursor conductor structure formed by the nanoparticles,
(b) covering the first foil layer (2) at least partially with the second foil layer (3) in such a fashion that the precursor conductor structure formed by the nanoparticles is covered at least partially by the second foil layer (3), and
(c) hot-laminating the first and the second foil layer (2, 3) and simultaneously sintering the metallic nanoparticles forming the precursor conductor structure to form the electroconductive conductor structure (5).

2. The method according to claim 1, **characterized in that** it has the following steps in addition:
applying, in the form of a second conductor structure (6), a dispersion containing metallic nanoparticles to a surface of the second foil layer (3) produce a second precursor conductor structure formed by the nanoparticles,
covering the second foil layer (3) at least partially with a third foil layer (4) in such a fashion that the second precursor conductor structure formed by the nanoparticles is covered at least partially by the third foil layer (4), and
hot-laminating the first, second and third foil layer (2, 3, 4) to form the laminate material (11), wherein the second foil layer (3) is arranged between the first and the second precursor conductor structure, and simultaneously sintering the metallic nanoparticles forming the precursor conductor structure to form the electroconductive first conductor structure (5) and the electroconductive second conductor structure (6).

3. The method according to claim 2, **characterized in that** it has the following steps in addition:
applying, in the form of a third conductor structure (7), a dispersion containing metallic nanoparticles to a surface of the third foil layer (4) to produce a third precursor conductor structure formed by the nanoparticles,
covering the third foil layer (4) at least partially with a further foil layer (10') in such a fashion that the third precursor conductor structure formed by the nanoparticles is covered at least partially by the further foil layer (10'), and
hot-laminating the first, second, third and fourth foil layer (2, 3, 4, 10') to form the laminate material (11), wherein the second foil layer (3) is arranged between the first and the second precursor conductor structure, and the third foil layer (4) is arranged between the second and the third precursor conductor structure, and simultaneously sintering the metallic nanoparticles forming the precursor conductor structures to form the first, second and third conductor structure (5, 6, 7).

4. The method according to claim 1, **characterized in that** it has the following steps in addition:
applying, in the form of a second conductor structure (6), a dispersion containing metallic nanoparticles to the other surface of the first foil layer (2) to produce a second precursor conductor structure formed by the nanoparticles,
covering the first foil layer (2) at least partially with a third foil layer (4) in such a fashion that the second precursor conductor structure formed by the nanoparticles is covered at least partially by the third foil layer (4), and
hot-laminating the first, the second and the third foil layer (2, 3, 4) to form the laminate material (11), wherein the first foil layer (2) is arranged between the first and the second precursor conductor structure, and simultaneously sintering the metallic nanoparticles forming the precursor conductor structures to form the electroconductive first and second conductor structure (5, 6).

5. The method according to claim 1, **characterized in that** it has the following steps in addition:
applying, in the form of a second conductor structure (6), a dispersion containing metallic nanoparticles to a surface of a third foil layer (4) to produce a second precursor conductor structure formed by the nanoparticles,
covering the first foil layer (2) and the third foil layer (4) at least partially with the second foil layer (3) in such a fashion that the first and second precursor conductor structure formed by the nanoparticles is covered respectively at least partially by the second foil layer (3), and
hot-laminating the first, the second and the third foil layer (2, 3, 4) to form the laminate material (11), wherein the second foil layer (3) is arranged between the first and the second precursor conductor structure, and simultaneously sintering the metallic nanoparticles forming the first and the second precursor conductor structure to form the electroconductive first and second conductor structure (5, 6).

6. The method according to any of the claims 2 to 5, **characterized in that** in the foil layers (2, 3, 4) separating adjacent conductor structures (5, 6, 7) contact windows (16) are formed for establishing an electroconductive connection between adjacent conductor structures.

7. The method according to claim 1, **characterized in that** it has the following steps in addition:
applying, in the form of a first and a second conductor structure (5, 6), a dispersion containing metallic nanoparticles to a surface of the first foil layer (2) to produce a first and second precursor conductor structure formed by the nanoparticles, and applying, in the form of a third conductor structure (7), a dispersion containing metallic nanoparticles to a surface of a third foil layer (4) to produce a third precursor conductor structure formed by the nanoparticles,
covering the first foil layer (2) and the third foil layer (4) at least partially with a second foil layer (3) having a through opening (17) in such a fashion that the first and second precursor conductor structure are covered substantially by the second foil layer (3), and that in the region of the opening (17) the first and second precursor conductor structure are so arranged that they overlap the third precursor conductor structure and are not covered by the second foil layer (3), and
hot-laminating the first, the second and the third foil layer (2, 3, 4) to form the laminate material (11), wherein the second foil layer (3) is arranged between the first and the second precursor conductor structure on the one hand, and the third precursor conductor structure on the other hand, and simultaneously sintering the metallic nanoparticles forming the first, second and third precursor conductor structure to form the first, second and third electroconductive conductor structure (5, 6, 7).

8. The method according to claim 1, **characterized in that** it has the following steps in addition:
applying, in the form of a second conductor structure (6), a dispersion containing metallic nanoparticles to a surface of a third foil layer (4) to produce a second precursor conductor structure formed by the nanoparticles,
covering the first foil layer (2) and the third foil layer (4) with a second foil layer (3) having a through opening (17) in such a fashion that the first and the second precursor conductor structure are covered substantially by the second foil layer (3), and are arranged in mutually overlapping fashion and are not covered by the second foil layer (3) in the region of the opening (17), and
hot-laminating the first, the second and the third foil layer (2, 3, 4) to form the laminate material (11), wherein the second foil layer (3) is arranged between the first and the second precursor conductor structure, and simultaneously sintering the metallic nanoparticles forming the first and the second precursor conductor structure to form the first and the second electroconductive conductor structure (5, 6).

9. The method according to any of the claims 1 to 8, **characterized in that** the hot laminating takes place at a temperature of 130°C to 150°C, while the foil layers (2, 3, 4, 10) are fixed in a laminating press.

10. The method according to any of the claims 1 to 9, **characterized in that** the precursor conductor structures are preferably dried at a temperature of up to 60°C, preferably up to 50°C, before covering with a foil layer (3, 4, 10).

11. The method according to any of the claims 1 to 10, **characterized in that** the dispersions containing nanoparticles are aqueous dispersions or solvent-based dispersions having a content of nanoparticles of 10 weight-% to 30 weight-% and/or having an average particle diameter of the nanoparticles of 20 nm to 1000 nm, wherein the nanoparticles are particles of pure metals or of metal alloys and are preferably chosen from the group consisting of silver, aluminum and copper-nickel alloys.

12. The method according to any of the claims 1 to 11, **characterized in that** the application of the dispersion containing the metallic nanoparticles takes places by a printing method, preferably by a printing method chosen from the group consisting of screen printing, flexographic printing, aerosol printing and ink-jet printing.

13. The method for manufacturing a laminate material (11) according to claim 1, **characterized in that** it has at least one functional element, such as an IC chip (12), and that the at least one conductor structure (5, 6, 7) forms a coil (13).

14. The method for manufacturing a laminate material (11) according to claim 1, **characterized in that** it has at least one functional element, such as an IC chip (12), and at least two conductor structures (5, 6, 7), wherein the conductor structures form a coil (13) or a switch (14).

15. The method for producing a chip card (1) or a chip card inlet having a plurality of foil layers (2, 3, 4, 10, 10') bonded by hot laminating and an electronic circuit unit having at least one IC chip (12) and at least one coil (13) and/or at least one foil switch (14), **characterized in that** the conductor structure of the coil and/or of the foil switch consists of sintered metallic nanoparticles and can be obtained according to a method according to any of the claims 1 to 12.

16. The method for manufacturing a chip card (1) according to claim 15, **characterized in that** it is a contactless data carrier.

## Revendications

1. Procédé de fabrication d'un matériau stratifié (11) qui comporte au moins une première couche de film (2), une deuxième couche de film (3) adjacente à la première couche de film et au moins une structure conductrice (5) électroconductrice entre la première et la deuxième couche de film, la première et la deuxième couche de film étant électriquement isolantes et se prêtant au laminage à chaud, **caractérisé par** les étapes suivantes:
(a) application d'une dispersion contenant des nanoparticules métalliques sous forme de la au moins une structure conductrice (5) sur une surface de la première couche de film (2) pour générer un précurseur de structure conductrice constitué des nanoparticules,
(b) recouvrement de la première couche de film (2) au moins partiellement par la deuxième couche de film (3) de telle sorte que le précurseur de structure conductrice constitué des nanoparticules est au moins partiellement recouvert par la deuxième couche de film (3), et
(c) laminage à chaud de la première et de la deuxième couche de film (2, 3) et frittage simultané des nanoparticules métalliques constituant le précurseur de structure conductrice de manière à obtenir la structure conductrice (5) électroconductrice .

2. Procédé selon la revendication 1, **caractérisé en ce qu'**il comporte en outre les étapes suivantes:
application d'une dispersion contenant des nanoparticules métalliques sous forme d'une deuxième structure conductrice (6) sur une surface de la deuxième couche de film (3) pour générer un deuxième précurseur de structure conductrice constitué des nanoparticules,
recouvrement de la deuxième couche de film (3) au moins partiellement par une troisième couche de film (4) de telle sorte que le deuxième précurseur de structure conductrice constitué des nanoparticules est au moins partiellement recouvert par la troisième couche de film (10'), et
laminage à chaud de la première, deuxième et troisième couche de film (2, 3, 4, 10') de manière à obtenir le matériau stratifié (11), ce qui a lieu **en ce que** la deuxième couche de film (3) est agencée entre le premier et le deuxième précurseur de structure conductrice, et frittage simultané des nanoparticules métalliques constituant les précurseurs de structures conductrices de manière à obtenir la première structure conductrice (5) électroconductrice et la deuxième structure conductrice (6) électroconductrice .

3. Procédé selon la revendication 2, **caractérisé en ce qu'**il comporte en outre les étapes suivantes:
application d'une dispersion contenant des nanoparticules métalliques sous forme d'une troisième structure conductrice (7) sur une surface de la troisième couche de film (4) pour générer un troisième précurseur de structure conductrice constitué des nanoparticules,
recouvrement de la troisième couche de film (4) au moins partiellement par une couche de film (10') supplémentaire de telle sorte que le troisième précurseur de structure conductrice constitué des nanoparticules est au moins partiellement recouvert par la couche de film (10') supplémentaire, et
laminage à chaud de la première, deuxième, troisième et quatrième couche de film (2, 3, 4, 10') de manière à obtenir le matériau stratifié (11), ce qui a lieu **en ce que** la deuxième couche de film (3) est agencée entre le premier et le deuxième précurseur de structure conductrice, et **en ce que** la troisième couche de film (4) est agencée entre le deuxième et le troisième précurseur de structure conductrice, et frittage simultané des nanoparticules métalliques constituant les précurseurs de structures conductrices de manière à obtenir la première, deuxième et troisième structure conductrice (5, 6, 7).

4. Procédé selon la revendication 1, **caractérisé en ce qu'**il comporte en outre les étapes suivantes:
application d'une dispersion contenant des nanoparticules métalliques sous forme d'une deuxième structure conductrice (6) sur l'autre surface de la première couche de film (2) pour générer un deuxième précurseur de structure conductrice constitué des nanoparticules,
recouvrement de la première couche de film (2) au moins partiellement par une troisième couche de film (4) de telle sorte que le deuxième précurseur de structure conductrice constitué des nanoparticules est au moins partiellement recouvert par la troisième couche de film (4), et
laminage à chaud de la première, de la deuxième et de la troisième couche de film (2, 3, 4) de manière à obtenir le matériau stratifié (11), ce qui a lieu **en ce que** la première couche de film (2) est agencée entre le premier et le deuxième précurseur de structure conductrice, et frittage simultané des nanoparticules métalliques constituant les précurseurs de structures conductrices de manière à obtenir la première et deuxième structure conductrice (5, 6) électroconductrice.

5. Procédé selon la revendication 1, **caractérisé en ce qu'**il comporte en outre les étapes suivantes:
application d'une dispersion contenant des nanoparticules métalliques sous forme d'une deuxième structure conductrice (6) sur une surface d'une troisième couche de film (4) pour générer un deuxième précurseur de structure conductrice constitué des nanoparticules,
recouvrement de la première couche de film (2) et de la troisième couche de film (4) au moins partiellement par la deuxième couche de film (3) de telle sorte que le premier et deuxième précurseur de structure conductrice constitué des nanoparticules est respectivement au moins partiellement recouvert par la deuxième couche de film (3), et
laminage à chaud de la première, de la deuxième et de la troisième couche de film (2, 3, 4) de manière à obtenir le matériau stratifié (11), ce qui a lieu **en ce que** la deuxième couche de film (3) est agencée entre le premier et le deuxième précurseur de structure conductrice, et frittage simultané des nanoparticules métalliques constituant le premier et le deuxième précurseurs de structures conductrices de manière à obtenir la première et deuxième structure conductrice (5, 6) électroconductrice.

6. Procédé selon une des revendications de 2 à 5, **caractérisé en ce que**, dans les couches de film (2, 3, 4) qui séparent des structures conductrices (5, 6, 7) adjacentes les unes aux autres, des fenêtres de contact (16) pour la fabrication d'une connexion électriquement conductrice entre des structures conductrices adjacentes sont réalisées.

7. Procédé selon la revendication 1, **caractérisé en ce qu'**il comporte en outre les étapes suivantes:
application d'une dispersion contenant des nanoparticules métalliques sous forme d'une première et d'une deuxième structure conductrice (5, 6) sur une surface de la première couche de film (2) pour générer un premier et deuxième précurseur de structure conductrice constitué des nanoparticules, et
application d'une dispersion contenant des nanoparticules métalliques sous forme d'une troisième structure conductrice (7) sur une surface d'une troisième couche de film (4) pour générer un troisième précurseur de structure conductrice constitué des nanoparticules,
recouvrement de la première couche de film (2) et de la troisième couche de film (4) par une deuxième couche de film (3) qui comporte une ouverture (17) continue, de telle sorte que le premier et le deuxième précurseur de structure conductrice sont essentiellement recouverts par la deuxième couche de film (3), et que, dans la zone de l'ouverture (17), le premier et deuxième précurseur de structure conductrice du troisième précurseur de structure conductrice sont agencés de manière se chevauchant et ne sont pas recouverts par la deuxième couche de film (3), et
laminage à chaud de la première, de la deuxième et de la troisième couche de film (2, 3, 4) de manière à obtenir le matériau stratifié (11), ce qui a lieu **en ce que** la deuxième couche de film (3) est agencée entre le premier et le deuxième précurseur de structure conductrice d'une part et le troisième précurseur de structure conductrice d'autre part, et frittage simultané des nanoparticules métalliques constituant le premier, deuxième et troisième précurseur de structures conductrices de manière à obtenir la première, deuxième et troisième structure conductrice (5, 6, 7) électroconductrice.

8. Procédé selon la revendication 1, **caractérisé en ce qu'**il comporte en outre les étapes suivantes:
application d'une dispersion contenant des nanoparticules métalliques sous forme d'une deuxième structure conductrice (6) sur une surface d'une troisième couche de film (4) pour générer un deuxième précurseur de structure conductrice constitué des nanoparticules,
recouvrement de la première couche de film (2) et de la troisième couche de film (4) par une deuxième couche de film (3) qui comporte une ouverture (17) continue, de telle sorte que le premier et le deuxième précurseur de structure conductrice sont essentiellement recouverts par la deuxième couche de film (3), et sont, dans la zone l'ouverture (17), agencés de manière se chevauchant et ne sont pas recouverts par la deuxième couche de film (3), et
laminage à chaud de la première, de la deuxième et de la troisième couche de film (2, 3, 4) de manière à obtenir le matériau stratifié (11), ce qui a lieu **en ce que** la deuxième couche de film (3) est agencée entre le premier et le deuxième précurseur de structure conductrice, et frittage simultané des nanoparticules métalliques constituant le premier et le deuxième précurseur de structure conductrice
de manière à obtenir la première et la deuxième structure conductrice (5, 6) électroconductrice.

9. Procédé selon une des revendications de 1 à 8, **caractérisé en ce que** le laminage à chaud est effectué à une température de 130°C à 150°C pendant que les couches de film (2, 3, 4, 10) sont fixées dans une presse de laminage.

10. Procédé selon une des revendications de 1 à 9, **caractérisé en ce que** les précurseurs de structures conductrices sont, avant le recouvrement par une couche de film (3, 4, 10), séchés à une température allant jusqu'à 60°, de préférence jusqu'à 50°C.

11. Procédé selon une des revendications de 1 à 10, **caractérisé en ce que** les dispersions contenant des nanoparticules métalliques sont des dispersions aqueuses ou des dispersions à base de solvants ayant une teneur en nanoparticules allant de 10 pourcent par poids à 30 pourcent par poids et/ou ayant un diamètre moyen de particules des nanoparticules allant de 20 nm à 1000 nm, les nanoparticules étant des particules de métaux purs ou d'alliages de métaux et étant de préférence sélectionnées parmi le groupe qui consiste en de l'argent, de l'aluminium et des alliages de cuivre-nickel.

12. Procédé selon une des revendications de 1 à 11, **caractérisé en ce que** l'application des dispersions contenant des nanoparticules métalliques a lieu par un procédé d'impression, de préférence par un procédé d'impression sélectionné parmi le groupe qui consiste en la sérigraphie, la flexographie, l'impression au jet d'aérosol ou l'impression jet d'encre.

13. Procédé de fabrication d'un matériau stratifié (11) selon la revendication 1, **caractérisé en ce qu'**il comporte au moins un élément fonctionnel tel qu'une puce de CI (12), et **en ce que** la au moins une structure conductrice (5, 6, 7) constitue une bobine (13).

14. Procédé de fabrication d'un matériau stratifié (11) selon la revendication 1, **caractérisé en ce qu'**il comporte au moins un élément fonctionnel tel qu'une puce de CI (12), et au moins deux structures conductrices (5, 6, 7), les structures conductrices constituant une bobine (13) ou un commutateur (14).

15. Procédé de fabrication d'une carte à puce (1) ou d'un intercalaire pour carte à puce,comportant une pluralité de couches de film (2, 3, 4, 10, 10') jointes par laminage à chaud et une unité de commutation électronique avec au moins une puce de CI (12) et au moins une bobine (13) et/ou au moins un commutateur à membrane (14), **caractérisé en ce que** la structure conductrice de la bobine et/ou du commutateur à membrane consiste en des nanoparticules métalliques frittées et est procurable suivant un procédé selon une des revendications de 1 à 12.

16. Procédé de fabrication d'une carte à puce (1) selon la revendication 15, **caractérisé en ce qu'**elle est un support de données sans contact.
